# EUROPEAN PATENT SPECIFICATION

(11) **EP 2 702 615 B1**
(45) Date of publication and mention of the grant of the patent: **11.03.2020**
(21) Application number: 12777257.2
(22) Date of filing: 26.04.2012
(51) Int. Cl.: H01L 31/042, H01L 31/18, H01L 31/0224, H01L 31/0749, H01L 31/0216, H01L 31/0296

(54) **METHOD OF PREPARING A SOLAR CELL**
HERSTELLUNGSVERFAHREN FÜR EINE SOLARZELLE
PROCÉDÉ DE FABRICATION D'UNE CELLULE SOLAIRE

(30) Priority: 26.04.2011 KR 20110039051
(43) Date of publication of application: 05.03.2014
(73) Proprietor: LG Innotek Co., Ltd., Seoul, 04637 (KR); Chung-Ang University Industry-Academy Cooperation, Dongjak-gu, Seoul 156-861 (KR)
(72) Inventor: CHOI, Chul Hwan, Seoul 100-714 (KR); CHOI, In Hwan, Seoul 100-714 (KR)
(74) Representative: Novagraaf Technologies
(86) International application number: PCT/KR2012/003270
(87) International publication number: WO 2012/148208

(56) References cited:
- CN-C- 1 285 129
- KR-A- 20100 025 068
- KR-A- 20110 012 314
- KR-A- 20110 013 009
- US-A1- 2010 210 064
- US-A1- 2010 233 841
- PLATZER-BJÖRKMAN C ET AL: "Zn(O,S) buffer layers by atomic layer deposition in Cu(In,Ga)Se2 based thin film solar cells: Band alignment and sulfur gradient", JOURNAL OF APPLIED PHYSICS, AMERICAN INSTITUTE OF PHYSICS, US, vol. 100, no. 4, 23 August 2006 (2006-08-23), pages 44506-044506, XP012089821, ISSN: 0021-8979
- SIEBENTRITT S: "Alternative buffers for chalcopyrite solar cells", SOLAR ENERGY, PERGAMON PRESS. OXFORD, GB, vol. 77, no. 6, 23 August 2004 (2004-08-23), pages 767-775, XP004661817, ISSN: 0038-092X, DOI: 10.1016/J.SOLENER.2004.06.018
- SEO: "Preparation of ZnS Thin Film Using Zn (dithiocarbamate)~ 2 Precursors by MOCVD Method", BULLETIN OF THE KOREAN CHEMICAL SOCIETY, vol. 26, no. 10, 2005, page 1582, XP055132197, ISSN: 0253-2964
- Paul O Brien ET AL: "Single-molecule Precursor Chemistry for the Deposition of Chalcogenide(S or Se)-containing Compound Semiconductors by MOCVD and Related Methods", J. MATER. CHEM, 1995, pages 1761-1773, XP055132202, Retrieved from the Internet: URL:http://pubs.rsc.org/en/content/article pdf/1995/JM/JM9950501761 [retrieved on 2014-07-29]
- IN-HWAN CHOI ET AL: "Improvement of the energy conversion efficiency of Cu(In,Ga)Se2 solar cells using an additional Zn(S,O) buffer", THIN SOLID FILMS, vol. 525, 5 October 2012 (2012-10-05), pages 132-136, XP055132049, ISSN: 0040-6090, DOI: 10.1016/j.tsf.2012.07.137

## Description

### Technical Field

The embodiment relates to a method of preparing a CIGS solar cell.

### Background Art

Recently, as energy consumption is increased, a solar cell has been developed to convert solar energy into electrical energy.

In particular, a CIGS-based solar cell, which is a PN hetero junction apparatus having a substrate structure including a glass substrate, a metallic back electrode layer, a P type CIGS-based light absorbing layer, a buffer layer, and an N type window layer, has been extensively used.

Various studies and research have been performed to improve electric characteristics of the solar cell, such as low resistance and high transmittance.

### Disclosure of Invention

### Technical Problem

The embodiment provides a solar cell, which can be prepared through an environment-friendly scheme by forming a buffer layer including ZnS and can improve productivity and photoelectric conversion efficiency, and a method of preparing the same.

### Solution to Problem

The present invention is defined in independent method claim 1.

A method of preparing a solar cell according to the embodiment includes the steps of forming a back electrode layer on a substrate; forming a light absorbing layer on the back electrode layer; forming a buffer layer including ZnS on the light absorbing layer through an MOCVD scheme by injecting a Zn precursor and an S precursor onto the light absorbing layer; and forming a window layer on the buffer layer.

### Advantageous Effects of Invention

According to the embodiment, the buffer layer including ZnS can be formed through the MOCVD (metal organic chemical vapor deposition), so the solar cell can solve the problem of environmental pollution caused by Cd, which is a hazardous heavy metal included in the buffer layer.

In addition, the buffer layer including ZnS can be formed in-line with the window layer, so the productivity can be improved.

Further, vapor (H₂O) is applied to a surface of the buffer layer including ZnS, so the solar cell may have the improved photoelectric conversion efficiency.

### Brief Description of Drawings

FIG. 1 is a sectional view showing a solar cell according to the embodiment;
FIG. 2 is a graph showing variation of quantum efficiency as a function of a wavelength of light incident into a CIGS solar cell prepared by growing CdS and ZnS buffer layers through the CBD (chemical bath deposition) scheme;
FIG. 3 is an SEM (scanning electron microscope) photographic view of a ZnS buffer layer grown through the CBD scheme;
FIG. 4 is an SEM photographic view of a ZnS buffer layer prepared through the MOCVD scheme;
FIG. 5 is a graph showing the I-V characteristic curve and power characteristic curve of a CIGS solar cell when the solar cell uses a CdS buffer prepared through the CBD and a ZnS buffer prepared through the MOCVD, respectively; and
FIGS. 6 to 9 are sectional views showing the procedure for manufacturing a solar cell panel according to the embodiment.

### Mode for the Invention

In the description of the embodiments, it will be understood that when a substrate, a layer, a film or an electrode is referred to as being on or under another substrate, another layer, another film or another electrode, it can be directly or undirectly on the other substrate, the other layer, the other film, or the other electrode, or one or more intervening layers may also be present. Such a position of the layer has been described with reference to the drawings. The size of the elements shown in the drawings may be exaggerated for the purpose of explanation and may not utterly reflect the actual size.

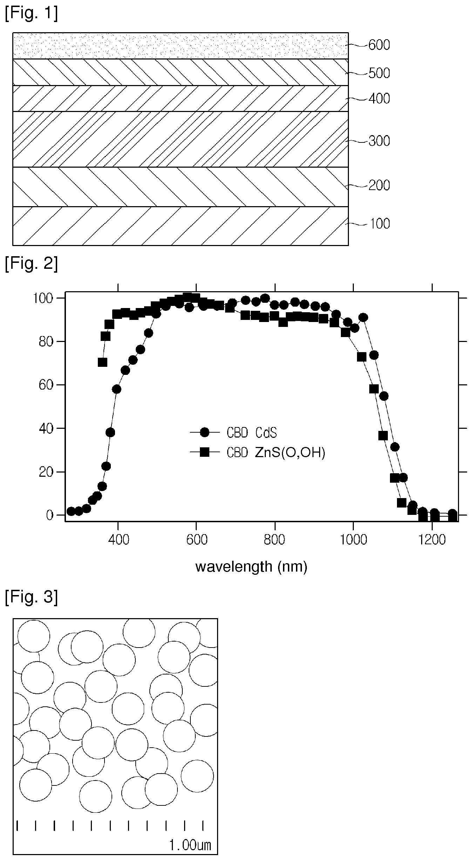

FIG. 1 is a sectional view showing a solar cell according to the embodiment. Referring to FIG. 1, the solar cell according to the embodiment includes a support substrate 100, a back electrode layer 200, a light absorbing layer 300, a buffer layer 400, a high-resistance window layer 500, and a low-resistance window layer 600.

The support substrate 100 may include an insulator. For example, the support substrate 100 may include a glass substrate, a plastic substrate such as polymer, or a metallic substrate. In more detail, the support substrate 100 may include a ceramic substrate including alumina, stainless steel (SUS), or polymer having a flexible property. The support substrate 100 may be transparent or may be rigid or flexible.

If the solar lime glass is used for the support substrate, sodium (Na) contained in the soda lime glass may diffuse to the CIGS light absorbing layer 300 during the process for preparing the solar cell. In this case, the charge concentration of the light absorbing layer 300 may be increased, so the photoelectric conversion efficiency of the solar cell may be increased.

The back electrode layer 200 is provided on the support substrate 100. The back electrode layer 200 is a conductive layer. The back electrode layer 200 may allow the movement of charges generated from the light absorbing layer 300, so current may flow out of the solar cell. To this end, the back electrode layer 200 may have high electric conductivity and low specific resistance.

In addition, the back electrode layer 200 must have stability under the high temperature when the heat treatment is performed in the sulfur (S) atmosphere or selenium (Se) atmosphere, which is realized when the CIGS compound is formed. In addition, the back electrode layer 200 must have superior adhesive property with respect to the support substrate 100 in such a manner that the back electrode layer 200 may not be delaminated from the support substrate 200 due to the difference in thermal expansion coefficient.

The back electrode layer 200 may include one selected from the group consisting of molybdenum (Mo), gold (Au), aluminum (Al), chrome (Cr), tungsten (W), and copper (Cu). Among the above materials, the Mo has a thermal expansion coefficient similar to that of the support substrate 100, so the Mo may improve the adhesive property and prevent the back electrode layer 200 from being delaminated from the substrate 100 while satisfying the characteristics required for the back electrode layer 200.

The back electrode layer 200 may include at least two layers. In this case, the layers may be formed by using the same metal or different metals.

The light absorbing layer 300 is provided on the back electrode layer 200. The light absorbing layer 300 may include a P type semiconductor compound. In detail, the light absorbing layer 300 may include a group I-III-VI₂ compound. For example, the light absorbing layer 300 may have the chalcopyrite crystal structure including CuInSe₂, CuGaSe₂ or Cu(In,Ga)Se₂, which is the solid solution of the CuInSe₂ and CuGaSe₂.

The energy bandgap of the light absorbing layer 300 is in the range of 1.04eV to 1.6eV under the normal temperature.

The buffer layer 400 is provided on the light absorbing layer 300. The solar cell employing the CIGS compound as the light absorbing layer 300 may form the PN hetero junction with a semiconductor having an energy bandgap higher than that of the light absorbing layer 300. At this time, the buffer layer is necessary when taking the difference in the crystalline structure and energy bandgap between the absorbing layer and the window layer.

The buffer layer 400 may include CdS, which is preferred in terms of the efficiency of the solar cell. However, Cd is a hazardous heavy metal causing the environment problem.

In addition, since the light absorbing layer 300 is formed through the printing method or the vacuum method (co-evaporation, sputtering and selenization, or MOCVD) and the low-resistance window layer 600 is formed through the vacuum method (sputtering or MOCVD), the process for forming the CdS or ZnS must be performed under the same atmosphere to improve the economic efficiency, to simplify the process and to reduce the manufacturing cost. However, according to the related art, the CdS is formed through the CBD (chemical bath deposition) scheme, so the in-line process is difficult.

In order to solve the above problem, ZnS, ZnSe, ZnO, (Zn,Mg)O, In(OH)₃, In₂S₃, InZnSeₓ, SnO₂, or SnS₂ has been suggested as a substitute for the CdS. The above materials may be deposited through the chemical bath deposition (CBD), atomic layer deposition (ALD), metal organic chemical vapor deposition (MOCVD), ion layer gas reaction (ILGAR), sputtering, thermal evaporation or electro-deposition(ED). Such solar cells are disclosed for example in PLATZER-BJORKMAN ET AL: "Zn(O,S) buffer layers by atomic layer deposition in Cu(In,Ga)Se2 based thin film solar cells: Band alignment and sulfur gradient", JOURNAL OF APPLIED PHYSICS 100, 044506 (2006) or in US 2010/233841A1.

Studies have been actively performed to replace CdS with ZnS. Although the CIGS solar cell including the ZnS buffer layer deposited through the CBD represents the efficiency lower than that of the solar cell employing CdS as a buffer, the CIGS solar cell including the ZnS buffer layer is suitable for the environmental-friendly requirement, so the CIGS solar cell including the ZnS buffer layer has been increasingly used.

Among the schemes for depositing the ZnS, the CBD scheme represents the highest energy conversion efficiency. The CBD scheme can obtain the highest energy conversion efficiency because the CBD scheme is performed under the low temperature condition and the Zn-O bonding or the O-H bonding may exist as well as the ZnS compound. Actually, referring to the IR (infrared) absorption spectrum of the ZnS layer grown through the CBD scheme, the absorption band caused by the coupled vibration mode of Zn-O or O-H has been observed in addition to the absorption band caused by the coupled vibration mode of Zn and S atoms.

According to the embodiment, the ZnS buffer layer 400 is formed through the MOCVD scheme and the H₂O precursor is applied onto the buffer layer 400 to improve the productivity and the photoelectric conversion efficiency. The ZnS buffer layer 400 may have the hexagonal system with the energy bandgap in the range of about 3.5eV to about 3.6eV.

The high-resistance buffer layer 500 is disposed on the buffer layer 400. The high-resistance buffer layer 500 includes i-ZnO, which is not doped with impurities.

The low-resistance buffer layer 600 is formed on the high-resistance buffer layer 500. The low-resistance buffer layer 600 is a transparent conductive layer. In addition, the low-resistance buffer layer 600 has resistance higher than that of the back electrode layer 200.

The low-resistance buffer layer 600 may include oxide. For instance, the low-resistance buffer layer 600 may include one of zinc oxide (ZnO), indium tin oxide (ITO) and indium zinc oxide (IZO).

In addition, the low-resistance buffer layer 600 may include group III_{B} elements, such as B (boron) or Al (aluminum) doped zinc oxide (BZO or AZO).

FIG. 2 is a graph showing variation of quantum efficiency as a function of a wavelength of light incident into the CIGS solar cell prepared by growing CdS and ZnS buffer layers through the CBD (chemical bath deposition) scheme.

As can be understood from the graph shown in FIG. 2, the solar cell employing ZnS as the buffer layer represents the superior quantum efficiency in the UV and IR bands as compared with the solar cell employing CdS as the buffer layer.

FIG. 3 is an SEM (scanning electron microscope) photographic view of the ZnS buffer layer grown through the CBD scheme. In general, a reagent used for growing the ZnS layer through the CBD scheme may include zinc sulfate (ZnSO4) or a hydrate as a Zn precursor, thiourea;(NH₂)₂CS as an S precursor, and NH₄OH aqueous solution (about 25 ∼ 28%) as a catalyst. A substrate is immersed in the above mixed solution and the temperature is increased in the range of 60°C to 90°C to deposit the ZnS layer.

The CBD scheme is performed under the relatively low deposition temperature, so group II metal atoms of ZnS or CdS serving as a deposition material may be prevented from diffusing to the CIGS absorbing layer serving as the substrate.

In addition, referring to the IR (infrared) absorption spectrum of the ZnS buffer layer 400 grown through the CBD scheme, the absorption band caused by the coupled vibration mode of Zn-O or O-H has been observed in addition to the absorption band caused by the coupled vibration mode of Zn and S atoms.

This is because the compound, such as ZnO or Zn(OH)₂, besides the ZnS compound, is bonded with OH- ions extracted from NH₄OH serving as the catalyst and Zn²⁺ ions dissociated from ZnS, so Zn(OH)2 is formed. For this reason, the ZnS layer grown through the CBD scheme is expressed as ZnS.

That is, due to O and OH, the CIGS solar cell including the ZnS buffer grown through the CBD scheme is advantageous than the solar cell including the ZnS buffer deposited through the vacuum deposition scheme in terms of the energy conversion efficiency.

However, as shown in FIG. 3, the buffer layer is not uniformly grown, and distributed in the form of small grains. In addition, since the buffer layer is grown in the liquid-phase similar to CdS, it may be difficult to simplify the manufacturing process for the CIGS solar cell.

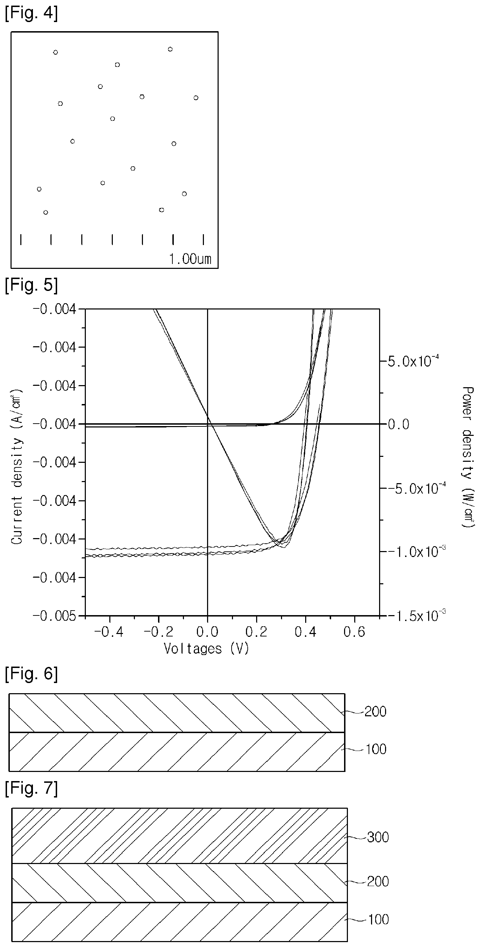

FIG. 4 is an SEM photographic view of the ZnS buffer layer prepared through the MOCVD scheme. As can be understood from FIG. 4, the ZnS buffer layer is uniformly grown as compared with the ZnS buffer layer grown through the CBD scheme as shown in FIG. 3.

According to the embodiment, the ZnS buffer layer is prepared through the MOCVD scheme, so the surface of the ZnS buffer layer may be uniform. In addition, H₂O is temporarily applied to the top surface of the ZnS buffer layer to form the ZnS(O,OH) layer, thereby improving the energy conversion efficiency.

FIG. 5 is a graph showing the I-V characteristic curve and power characteristic curve of the CIGS solar cell when the solar cell uses a CdS buffer prepared through the CBD scheme and a ZnS buffer prepared through the MOCVD scheme, respectively. At this time, CIGS absorbing layers have the same compositional ratio and are prepared under the same condition.

In the graph, a red line represents the CdS buffer layer and a blue line represents the ZnS buffer layer. The I-V characteristic curves of the two buffer layers were almost similar to each other. In detail, the I-V characteristic curve of the ZnS buffer layer was slightly better than that of the CdS buffer layer. Two samples shown in the graph represented the superior reverse characteristics. When taking into consideration the I-V characteristics of several solar cells in terms of the statistics, the reverse characteristic of the ZnS buffer layer was better than that of the CdS buffer layer. The I-V characteristics shown in the graph were measured in the room under the fluorescent lamp. Thus, negative values were represented in the current density. In the I-V characteristics measured under the fluorescent lamp, the light source was not the standard light source, so the curve represented random values.

Since the energy conversion efficiency seriously relates to the characteristics of the absorbing layer, the same absorbing layer was used to compare the difference in characteristics between two buffer layers and the relative efficiency between two samples subject to the comparison may be more important than the absolute efficiency.

FIGS. 6 to 9 are sectional views showing the procedure for manufacturing the solar cell panel according to the embodiment. The above description about the solar cell will be incorporated herein by reference.

Referring to FIGS. 6 and 7, the back electrode layer 200 is formed on the support substrate 100. The back electrode layer 200 may be deposited by using molybdenum (M). The back electrode layer 200 may be formed through a PVD (Physical Vapor Deposition) scheme or a plating scheme.

An intervening layer, such as a diffusion-barrier layer, may be disposed between the support substrate 100 and the back electrode layer 200.

Then, the light absorbing layer 300 is formed on the back electrode layer 200. For instance, the light absorbing layer 300 may be formed through various schemes such as a scheme of forming a Cu(In,Ga)Se₂ (CIGS) based light absorbing layer 300 by simultaneously or separately evaporating Cu, In, Ga, and Se and a scheme of performing a selenization process after a metallic precursor layer has been formed.

Regarding the details of the selenization process after the formation of the metallic precursor layer, the metallic precursor layer is formed on the back electrode layer 200 through a sputtering process employing a Cu target, an In target, a Ga target or an alloy target.

Thereafter, the metallic precursor layer is subject to the selenization process so that the Cu (In, Ga) Se₂ (CIGS) based light absorbing layer 300 is formed.

In addition, the sputtering process employing the Cu target, the In target, and the Ga target and the selenization process may be simultaneously performed.

Further, a CIS or a CGS based light absorbing layer 300 may be formed through the sputtering process employing only Cu and In targets or only Cu and Ga targets and the selenization process.

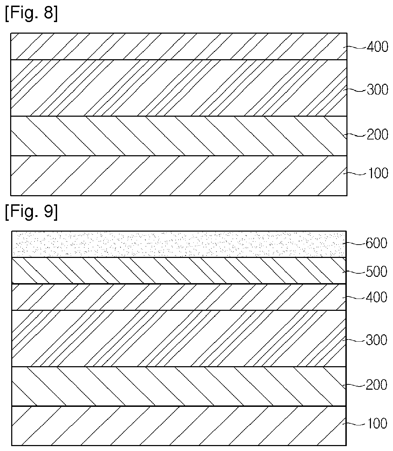

Referring to FIGS. 8 and 9, the buffer layer 400 is formed on the light absorbing layer 300. The buffer layer 400 can be formed in the temperature of 150°C to 250°C. The buffer layer includes ZnS, TEZn (triethyl zinc) can be used as a Zn precursor and t-BuSH (tert-butylthiol) can be used as an S precursor. When the compound buffer layer is grown through the MOCVD scheme, the selection of the precursor seriously relates to the growth condition and the physical property of the buffer layer.

The precursors described above are not the exclusive examples used to prepare the ZnS buffer layer 400. For instance, the Zn precursor may include R₂Zn, R₂ZnNEt₃ and the like (wherein, R is an alkyl group of C₁∼C₆, and Et is ethanol). In addition, the S precursor may include R₂S, RSH, H₂S gas and the like.

The buffer layer 400 may have the thickness in the range of 10nm to 50nm, preferably, 25nm to 35nm. Since the buffer layer 400 has a thin thickness, the growth rate of the ZnS buffer layer 400 may not be serious and the ZnS buffer layer 400 may have the desired thickness within a short period of time even if the substrate temperature is relatively low when the ZnS buffer layer 400 is grown through the MOCVD scheme. Thus, the low growth temperature can be adopted, so that the Zn atoms can be prevented from diffusing to the CIGS absorbing layer.

In general, an ionic radius of a Zn atom is about 7.4x10⁻¹⁰m and an ionic radius of a Cd atom is about 9.7x10⁻¹⁰m. When comparing with the ionic radius of a Cu atom (about 7.2x10⁻¹⁰m), the ionic radius of the Zn atom is closer to the ionic radius of the Cu atom.

For this reason, the diffusivity of the Zn atoms in the CIGS absorbing layer is significantly greater than that of the Cd atoms and the Zn atoms may be readily diffused under the relatively low temperature, so the Zn atoms may substitutes for V_{Cu} so that Zn_{Cu} is formed. The defect derived from the above reaction may serve as a donor and the donor changes the conductive characteristic of the P type CIGS absorbing layer, thereby lowering the energy conversion efficiency or causing the short.

As described above, even if the ZnS buffer layer is prepared under the relatively low substrate temperature, the Zn atoms may diffuse into the CIGS absorbing layer so that the electric characteristic of the CIGS absorbing layer may be changed.

According to the embodiment, in order to prevent the Zn atoms from diffusing into the CIGS absorbing layer, the S precursor is primarily applied to the light absorbing layer 300 to ensure the S atmosphere and then the Z precursor is applied to form the ZnS compound through the reaction between the Zn atoms and the S atoms, thereby preventing the Zn atoms from diffusing into the light absorbing layer 300.

Since the S precursor is primarily applied, the S density may have the maximum value at the lower portion of the buffer layer 400.

Referring to the I-V characteristic of samples, which were prepared by varying the turn-on time of the S precursor and the Zn precursor, the short was represented in all samples when the S precursor was not primarily applied or the Zn precursor was primarily applied, and the superior I-V characteristic was obtained when the Zn precursor was applied after primarily applying the S precursor.

The short represents that the acceptor level by V_{Cu} formed in the P type CIGS absorbing layer is changed to the Zn_{Cu} donor level due to the diffusion of the Zn atoms, so that the electric characteristic is changed into the electric characteristic of an N type CIGS absorbing layer.

After forming the ZnS buffer layer 400 through the MOCVD scheme, H₂O is applied to the surface of the ZnS buffer layer 400 for a predetermined time by using the H₂O precursor before the ZnO high-resistance window layer 500 is formed to change the ZnS buffer layer 400 into ZnS (O, OH), and then the Zn precursor is applied to form the i-ZnO high-resistance window layer 500.

The solar cell, which is prepared by primarily applying vapor of the H₂O precursor onto the substrate 100 loaded in the chamber for a predetermined time and then applying vapor of the Zn precursor, represents the superior I-V characteristics. This is because ZnO or Zn(OH)₂ is partially created in the ZnS buffer layer 400, so the ZnS buffer layer 400 is similar to the buffer layer grown through the CBD scheme, so that the I-V characteristics can be improved.

Then, the low-resistance window layer 600 is formed on the high-resistance window layer 500. In general, the low-resistance window layer 600 is deposited by using the material used for the high-resistance window layer 500. At this time, the dopant is also deposited to impart the conductive characteristic to the low-resistance window layer 600.

## Claims

1. A method of preparing a CIGS solar cell, the method comprising:
forming a back electrode layer (200) on a substrate (100);
forming a light absorbing layer (300) on the back electrode layer (200);
forming a buffer layer (400) including ZnS on the light absorbing layer (300) through an MOCVD(Metal Organic Chemical Vapor Deposition) scheme by injecting a Zn precursor and an S precursor onto the light absorbing layer (300); and
forming a window layer (500) on the buffer layer (400),
wherein the forming of the buffer layer (400) comprises:
applying a S precursor to the light absorbing layer (300), then
applying a Zn precursor to the light absorbing layer (300) in order to form the buffer layer (400) including ZnS compound through the reaction between the Zn atoms and the S atoms,
applying H₂O onto the buffer layer (400) to convert ZnS into ZnS(O, OH).

2. The method of claim 1, wherein the Zn precursor includes at least one of TEZn, R₂Zn, and R₂ZnNEt₃ and the S precursor includes at least one of tert-butylthiol (t-BuSH), R₂S, RSH, and H₂S gas, where R is an alkyl group of C₁∼C₆ and Et is ethanol.

3. The method of claim 1, wherein the buffer layer (400) is formed at a temperature in a range of 150°C to 250°C.

4. The method of claim 1, wherein, after forming the ZnS buffer layer (400) through the MOCVD, H₂O is applied to the surface of the ZnS buffer layer (400) for a predetermined time by using the H₂O precursor before the ZnO high-resistance window layer (500) is formed to change the ZnS buffer layer (400) into ZnS (O, OH), and then the Zn precursor is applied to form the i-ZnO high-resistance window layer (500).

## Patentansprüche

1. Verfahren zur Herstellung einer CIGS-Solarzelle, wobei das Verfahren umfasst:
Bilden einer Rückelektrodenschicht (200) auf einem Substrat (100);
Bilden einer lichtabsorbierenden Schicht (300) auf der Rückelektrodenschicht (200);
Bilden einer Pufferschicht (400), die ZnS beinhaltet, auf der lichtabsorbierenden Schicht (300) durch eine MOCVD (metallorganische Gasphasenabscheidung) durch Spritzen eines Zn-Vorläufers und eines S-Vorläufers auf die lichtabsorbierende Schicht (300); und
Bilden einer Fensterschicht (500) auf der Pufferschicht (400),
wobei das Bilden der Pufferschicht (400) umfasst:
Aufbringen eines S-Vorläufers auf die lichtabsorbierende Schicht (300), dann
Aufbringen eines Zn-Vorläufers auf die lichtabsorbierende Schicht (300), um die Pufferschicht (400), die eine ZnS-Verbindung durch die Reaktion zwischen den Zn-Atomen und den S-Atomen beinhaltet, zu bilden,
Aufbringen von H₂O auf die Pufferschicht (400), um ZnS in ZnS(O, OH) umzuwandeln.

2. Verfahren nach Anspruch 1, wobei der Zn-Vorläufer mindestens eines von TeZn, R₂Zn und R₂ZnNEt₃ beinhaltet und der S-Vorläufer mindestens eines von tert.-Butylthiol- (t-BuSH-), R₂S-, RSH- und H₂S-Gas beinhaltet, wobei R eine Alkylgruppe von C₁∼C₆ ist und Et Ethanol ist.

3. Verfahren nach Anspruch 1, wobei die Pufferschicht (400) bei einer Temperatur in einem Bereich von 150 °C bis 250 °C gebildet wird.

4. Verfahren nach Anspruch 1, wobei nach dem Bilden der ZnS-Pufferschicht (400) durch die MOCVD H₂O auf die Oberfläche der ZnS-Pufferschicht (400) für eine vorherbestimmte Zeit durch Verwenden des H₂O-Vorläufers aufgebracht wird, bevor die ZnO-Hochwiderstandsfensterschicht (500) gebildet wird, um die ZnS-Pufferschicht (400) zu ZnS(O, OH) zu ändern, und dann der Zn-Vorläufer aufgebracht wird, um die i-ZnO-Hochwiderstandsfensterschicht (500) zu bilden.

## Revendications

1. Procédé de préparation d'une cellule solaire CIGS, le procédé comprenant :
la formation d'une couche d'électrode arrière (200) sur un substrat (100) ;
la formation d'une couche absorbant la lumière (300) sur la couche d'électrode arrière (200) ;
la formation d'une couche tampon (400) comprenant du ZnS sur la couche absorbant la lumière (300) par l'intermédiaire d'un schéma MOCVD (dépôt chimique en phase vapeur organométallique) en injectant un précurseur de Zn et un précurseur de S sur la couche absorbant la lumière (300) ; et
la formation d'une couche de fenêtre (500) sur la couche tampon (400),
dans lequel la formation de la couche tampon (400) comprend :
l'application d'un précurseur de S sur la couche absorbant la lumière (300), puis
l'application d'un précurseur de Zn sur la couche absorbant la lumière (300) afin de former la couche tampon (400) incluant un composé de ZnS par l'intermédiaire de la réaction entre les atomes Zn et des atomes S,
l'application d'H₂O sur la couche tampon (400) pour convertir ZnS en ZnS(O, OH).

2. Procédé selon la revendication 1, dans lequel le précurseur de Zn comprend au moins l'un parmi TEZn, R₂Zn et R₂ZnNEt₃ et le précurseur de S comprend au moins l'un parmi le tert-butylthiol (t-BuSH), R₂S, RSH et H₂S gazeux, R étant un groupe alkyle en C₁∼C₆ et Et étant l'éthanol.

3. Procédé selon la revendication 1, dans lequel la couche tampon (400) est formée à une température située dans une plage allant de 150 °C à 250 °C.

4. Procédé selon la revendication 1, dans lequel, après la formation de la couche tampon de ZnS (400) par le MOCVD, de l'H₂O est appliqué sur la surface de la couche tampon de ZnS (400) pendant un temps prédéterminé en utilisant le précurseur d'H₂O avant la formation de la couche de fenêtre de ZnO à haute résistance (500) pour changer la couche tampon de ZnS (400) en ZnS(O, OH), et ensuite le précurseur de Zn est appliqué pour former la couche de fenêtre d'i-ZnO à haute résistance (500).
